# EUROPÄISCHE PATENTSCHRIFT

(11) **EP 0 724 787 B1**
(45) Veröffentlichungstag und Bekanntmachung des Hinweises auf die Patenterteilung: **22.07.1998**
(21) Anmeldenummer: 94931538.6
(22) Anmeldetag: 21.10.1994
(51) Int. Cl.: H02B 1/30, H02B 1/38

(54) **SCHALTSCHRANK MIT EINEM RAHMENGESTELL AUS RAHMENSCHENKELN**
SWITCH CUPBOARD WITH A RACK MADE OF FRAME PIECES
ARMOIRE DE DISTRIBUTION A BATI CONSTITUE DE MONTANTS

(30) Priorität: 23.10.1993 DE 4336203
(43) Veröffentlichungstag der Anmeldung: 07.08.1996
(73) Patentinhaber: Rittal-Werk Rudolf Loh GmbH & Co. KG, 35745 Herborn (DE)
(72) Erfinder: BESSERER, Horst, D-35745 Herborn (DE); MÜNCH, Udo, D-37764 Sinn (DE); NEUHOF, Markus, D-35630 Ehringshausen (DE); NICOLAI, Walter, D-35418 Buseck (DE); PAWLOWSKI, Adam, D-35690 Dillenburg (DE); SCHÜLER, Matthias, D-35716 Dietzhölztal (DE); STRACKBEIN, Heinrich, D-35444 Biebertal (DE)
(74) Vertreter: Fleck, Hermann-Josef, Dr.-Ing.
(86) Internationale Anmeldenummer: EP9403463
(87) Internationale Veröffentlichungsnummer: WO9511538

(56) Entgegenhaltungen:
- EP-A- 0 281 983
- DE-A- 2 659 483
- DE-C- 3 828 288
- DE-U- 7 534 322
- FR-A- 2 615 684

## Beschreibung

Nach dem Oberbegriff des Anspruchs 1 geht die erste Erfindung von einem Schaltschrank mit einem Rahmengestell aus Rahmenschenkeln aus, wie er durch die DE-A-26 59 483 als bekannt ausgewiesen ist. Bei diesem bekannten Schaltschrank sind die vertikalen Rahmenschenkel im wesentlichen als Vierkant-Hohlprofile ausgebildet, die auf ihren parallel zur Schranktür verlaufenden Seiten senkrecht nach innen in den Schaltschrank abstehende Stege aufweisen. An dem zum Inneren des Rahmengestelles gerichteten, senkrecht zu der Tür-Außenseite stehenden Profilabschnitt ist eine zum Innenraum des Rahmengestelles hin offene Aufnahmenut eingeformt, in die ein auf der Innenseite der Schranktür gelagertes Schließelement einführbar ist. Aufgrund dieser Ausbildung der Rahmenschenkel sind die Montagemöglichkeiten hinsichtlich der Scharnierung und der Türverschlüsse eingeschränkt.

Nach dem Oberbegriff des Patentanspruchs 2 geht die zweite Erfindung von einem Schaltschrank aus, wie er in der EP-A-0 281 983 angegeben ist. Bei diesem bekannten Schaltschrank weisen die vertikalen Rahmenschenkel ebenfalls senkrecht zu den zugeordneten Außenseiten des Rahmengestells stehende Innenprofilabschnitte auf. Die Innenprofilabschnitte tragen zum Innenraum des Rahmengestells gerichtete, parallel zu den zugeordneten Außenseiten des Rahmengestells verlaufende Haltestege, die von einem Verschlußriegel hintergriffen werden, der parallel zur Türebene verschwenkbar ist. Hinsichtlich der Montage ergibt sich dabei der Nachteil, daß der Verschluß relativ weit von dem vertikalen Rand des Rahmengestells entfernt angeordnet ist.

Nach dem Oberbegriff des Anspruchs 3 geht die dritte Erfindung von einem Schaltschrank aus, wie er ebenfalls in der Entgegenhaltung DE-A-2 659 483 offenbart ist. Auch hier kommt hinsichtlich der Montage der Nachteil zum tragen, daß eine Aufnahme für das Schließelement nur in dem einen, zur Außenseite senkrecht stehenden Innenprofilabschnitt vorgesehen ist.

Ein weiterer Schaltschrank mit einem Rahmengestell aus Rahmenschenkeln ist in der FR-A-2 615 684 beschrieben. Bei den vertikalen Rahmenschenkeln ist dabei lediglich ein zum Inneren des Rahmengestells gerichteter Innenprofilabschnitt 3 vorgesehen, der senkrecht auf einer Außenseite des Rahmengestells steht. Dieser Innenprofilabschnitt ist mit einem nach außen abgebogenen, zum Inneren des Rahmengestells gerichteten Schenkel 5 versehen. Der auf der anderen Außenseite des Rahmengestells liegende Profilabschnitt 4 ist an seinem Ende senkrecht nach außen abgebogen. Auch ein derartig aufgebautes Rahmengestell ist hinsichtlich der Montage nachteilig, da dabei die Ausrichtung und Anordnung der vertikalen Rahmenschenkel beachtet und die Türen entsprechend ausgerichtet und mit Verschluß- und Scharnierelementen versehen werden müssen.

In der DE-U 75 34 322 ist ein weiterer Schaltschrank angegeben, bei dem die vertikalen Rahmenschenkel und an der Tür vorgesehene Hohlprofile komplementäre Ausformungen aufweisen. In ein an der Tür vorgesehenes Hohlprofil ragt der Türverschluß mit einem Schloßzylinder und einem Riegel zum größten Teil hinein. Bei diesem bekannten Schaltschrank müssen die vertikalen Rahmenschenkel und die Hohlprofile der Tür aufeinander ausgerichtet sein, so daß sich auch dabei Nachteile hinsichtlich des Aufbaus und der Montage ergeben. Eine nachträgliche Anordnung einer Tür, beispielsweise an einer senkrecht angeordneten Außenseite, ist nicht möglich.

Ein weiterer Schaltschrank ist aus der DE 33 44 598 C1 bekannt. Dabei müssen an dem der Schließseite einer Schranktür zugekehrten vertikalen Rahmenschenkel für die Schließelemente der Schranktür komplementäre Schließelemente angebracht werden. Dies bedingt einen erheblichen Montage- und Teileaufwand insbesondere dann, wenn die Schranktür an mehreren Stellen Schließelemente trägt. Außerdem ist für den Fall, daß eine andere Seite des Rahmengestelles mit der Schranktür verschlossen werden soll, die Umrüstungsarbeit ganz beachtlich, da an einem Rahmenschenkel die komplementären Schließelemente abgenommen und an einem anderen Rahmenschenkel wieder angebracht werden müssen.

Den Erfindungen liegt die Aufgabe zugrunde, bei Schaltschränken gemäß dem Oberbegriff der Ansprüche 1, 2 oder 3 ohne großen Montage- und Teileaufwand eine Schranktür an beliebiger Seite des Rahmengestells verschließen und wieder öffnen zu können, wobei auch ein Umrüsten des Schaltschrankes, d.h. ein Versetzen der Schranktür, mit wenig Montageaufwand möglich ist.

Diese Aufgabe wird erfindungsgemäß mit den Merkmalen der Ansprüche 1 bis 3 auf einfache Weise gelöst.

In allen Fällen übernehmen die vertikalen Rahmenschenkel des Rahmengestelles mit den zusätzlichen Aufnahmenuten, Haltestegen, Absätzen oder Aufnahmen die Funktion der komplementären Schließelemente, so daß dafür keine zusätzlichen Teile und keine Montage für dieselben erforderlich sind. Da alle vier vertikalen Rahmenschenkel mit diesen Elementen versehen sind, kann jede beliebige Seite des Rahmengestelles mit einer Schranktür verschlossen werden.

Darüber hinaus ist noch vorgesehen, daß die vertikalen Rahmenschenkel des Rahmengestelles symmetrisch zu einer zwischen den senkrecht aufeinanderstoßenden Außenseiten des Rahmengestelles verlaufenden Diagonale ausgebildet und ausgerichtet sind, so daß sich alle Seiten des Rahmengestelles mit Schranktüren verschließen lassen.

Nach einer Ausgestaltung ist vorgesehen, daß die Schließelemente in einem Hohlprofilabschnitt gelagert sind, der im Bereich der Schließseite auf der Innenseite der Schranktür befestigt ist und daß die Schließelemente mittels Handhaben oder eines Schlosses von der Außenseite der Schranktür aus bedienbar sind. Die Schließelemente lassen sich dmait geschützt an der Schranktür anbringen.

Ist vorgesehen, daß die Schließelemente mittels Federn abgefedert sind, dann kann eine Art Verspannung der Schranktür an dem Rahmengestell erreicht werden und die Toleranzen der Bauteile lassen sich damit ausgleichen.

Die Verschlußart kann dabei so ausgeführt sein, daß die Schließelemente einer Schranktür einzeln oder gemeinsam verstellbar sind.

Eine Ausgestaltung der Schließelemente ist dadurch gekennzeichnet, daß die Schließelemente als federbelasteter Schieber ausgebildet sind, die mittels einer in dem Hohlprofilabschnitt axial verstellbaren Betätigungsstange über einen Durchbruch des Hohlprofilabschnittes aus diesem herausführbar und wieder in diesen hineinführbar sind.

Die Schließelemente lassen sich nach einer weiteren Ausgestaltung auch so ausführen, daß die Schließelemente als Schließhaken ausgebildet sind, die mittels einer im Hohlprofilabschnitt drehbar gelagerten federbelasteten Betätigungswelle verschwenkbar sind und aus dem Hohlprofilabschnitt ragen, so daß sie hinter den zugekehrten Haltesteg oder in die Aufnahme des zugekehrten Innenprofilabschnittes einführbar und wieder herausführbar sind.

Die Erfindung wird anhand von verschiedenen, in den Zeichnungen dargestellten Ausführungsbeispielen, die jeweils nur im Teilschnitt die Verbindung der Schranktür im Schließbereich mit einem vertikalen Rahmenschenkel darstellen, näher erläutert. Es zeigen:
- Fig. 1: einen vertikalen Rahmenschenkel mit Aufnahmenuten für einen an der Schranktür verschiebbar gelagerten Schieber als Schließelement,
- Fig. 2: einen Teilschnitt auf den im Hohlprofilabschnitt der Schranktür gelagerten und verstellbaren Schieber,
- Fig. 3: einen vertikalen Rahmenschenkel mit Haltestegen für ein als Schließhaken ausgebildetes Schließelement und
- Fig. 4: einen vertikalen Rahmenschenkel mit Aufnahmen, in die ein als Schließhaken ausgebildetes Schließelement einführbar und wieder herausführbar ist.

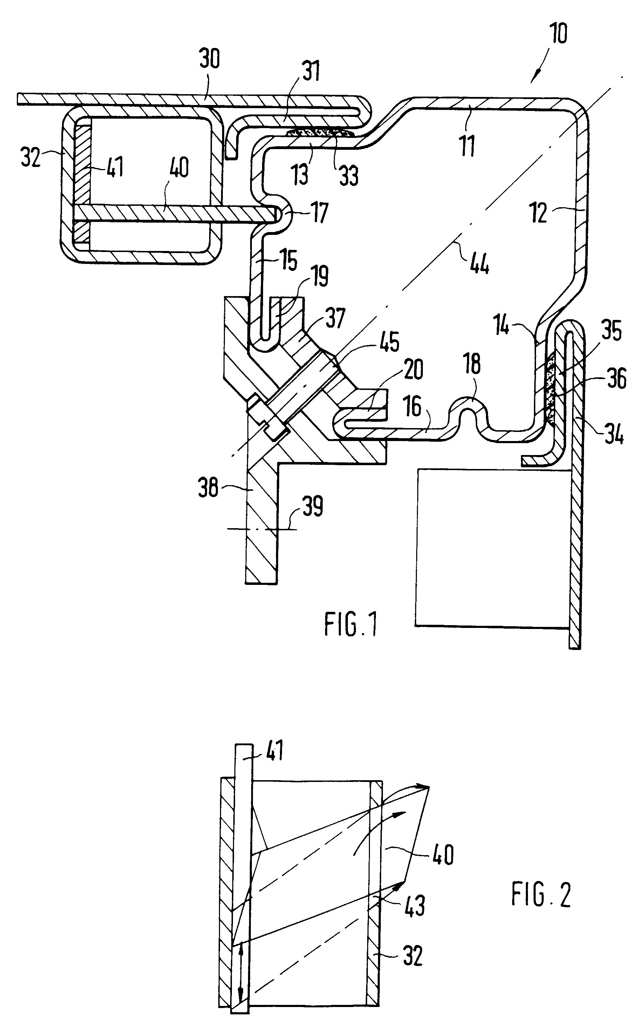

Im Ausführungsbeispiel nach Fig. 1 bildet das offene Hohlprofil einen vertikalen Rahmenschenkel 10 eines Rahmengestelles und mit den Profilabschnitten 11 und 12 die Außenseiten des Rahmengestelles. Der Querschnitt des Rahmenschenkels 10 ist symmetrisch zu der zwischen den Profilabschnitten 11 und 12 verlaufenden Diagonale 44. Die der Außenkante des Rahmenschenkels 10 abgekehrten Enden der Profilseiten 11 und 12 sind nach innen versetzt, wie die Profilabschnitte 13 und 14 zeigen. Dabei kann ein Dichtungselement 33 am Profilabschnitt 13 die Abdichtung zwischen dem Rahmenschenkel 10 und einer Schließseite einer Schranktür 30 übernehmen, die im Bereich der vertikalen Schließkante doppelwandig ausgebildet ist, wie der eingebogene Rand 31 erkennen läßt. An dem eingebogenen Rand 35 eines Wandelementes 34 ist ein Dichtungselement 36 angebracht, das die Abdichtung zwischen dem Wandelement 34 und dem Rahmenschenkel 10 übernimmt.

Die Profilabschnitte 13 und 14 gehen in rechtwinklig nach innen gebogene Innenprofilabschnitte 15 und 16 über, in die jeweils eine zum Innenraum des Rahmengestelles offene Aufnahmenut 17 bzw. 18 eingeformt ist, bevor die Innenprofilabschnitte 15 und 16 an den Enden als Verbindungsabschnitte 19 und 20 eingebogen sind und eine Aufnahme zum Anbringen eines Befestigungsprofiles 38 bilden. Dieses Befestigungsprofil 38 weist eine Reihe von Befestigungsaufnahmen 39 auf und wird mittels einer Klammer 37 und einer Klemmschraube 45 am Rahmenschenkel 10 festgelegt.

Auf der Innenseite der Schranktür 30 ist ein Hohlprofilabschnitt 32 befestigt, in dem eine Betätigungsstange 41 axial verstellbar geführt ist, wie der Teilschnitt nach Fig. 2 zeigt. Die Betätigungsstange 41 kann mittels einer auf der Außenseite der Schranktür 30 zugänglichen Handhabe in beiden Richtungen verstellt werden. Die Axialbewegung der Schubstange 41 kann auch über einen Verschluß gesteuert werden, der eine Drehbewegung der Handhabe in die Axialbewegung der Betätigungsstange 41 umsetzt. Bei der Verstellung der Betätigungsstange 41 nach oben (Fig. 2) wird ein als Schieber ausgebildetes Schließelement 40 durch einen Durchbruch 43 des Hohlprofilabschnittes 32 herausbewegt und in die Aufnahmenut 17 des Innenprofilabschnittes 15 eingeführt. Die Schranktür 30 ist dann geschlossen. Dabei kann das Schließelement 40 abgefedert sein, um Toleranzen auszugleichen. Wenn die Betätigungsstange 41 wieder nach unten (Fig. 2) bewegt wird, dann wird das Schließelement 40 wieder in den Hohlprofilabschnitt 32 eingezogen und dabei aus der Aufnahmenut 17 des Innenprofilabschnittes 15 herausgeführt. Die Schranktür 30 kann nun geöffnet werden.

Anstelle der Aufnahmenuten 17 und 18 können die Innenprofilabschnitte 15 und 16 um einen Absatz aufweisen, der von dem Schließelement 40 hintergriffen werden kann.

Da der Rahmenschenkel 10 symmetrisch ausgebildet ist, kann anstelle des Wandelementes 34 eine weitere Schranktür mit der Schließseite an dem Rahmenschenkel 10 festgelegt werden.

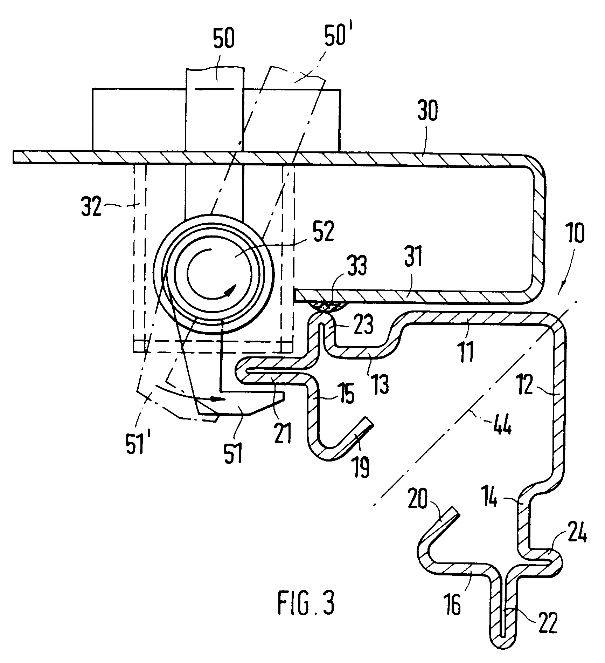

Bei dem Ausführungsbeispiel nach Fig. 3 sind die zurückgesetzten Profilabschnitte 13 und 14 an den Enden doppellagig nach außen abgebogen, so daß Dichtungsstege 23 und 24 gebildet sind, welche mit Dichtungselementen 33 an der Schranktür 30 bzw. dem Wandelement die Abdichtung übernehmen. Die Innenprofilabschnitte 15 und 16 weisen einen Haltesteg 21 bzw. 22 auf, der jeweils parallel zur zugeordneten Außenseite des Rahmengestelles, d.h. der Profilseiten 11 und 12, verläuft. Die Haltestege 21 und 22 werden durch aufeinanderliegende Profilabschnitte gebildet. Die Verbindungsabschnitte 19 und 20 verlaufen bei diesem Rahmenschenkel 10 parallel zur Diagonale 44 und sind im gleichen Abstand zu derselben angeordnet.

Auf der Innenseite der Schranktür 30, deren Rand 31 über das Dichtungselement 33 abgedichtet ist, ist wieder ein Hohlprofilabschnitt 32 befestigt, in dem eine abgefederte Betätigungswelle 52 drehbar gelagert ist. Die Betätigungswelle 52 ist mittels einer auf der Außenseite der Schranktür 30 zugänglichen Handhabe 50 in beiden Drehrichtungen begrenzt verdrehbar. Dabei wird ein als Schließhaken ausgebildetes Schließelement 51 verschwenkt. In der Schließstellung drückt das Federelement den Schließhaken hinter den Haltesteg 21, wobei die Schranktür 30 gegen den Rahmenschenkel 10 gezogen wird und die Toleranzen der Bauteile ausgeglichen werden. Wird die Handhabe 50 in die Stellen 50' gebracht, wobei die Federspannung zunimmt, dann gibt der Schließhaken den Haltesteg 21 frei und die Schranktür 30 kann geöffnet werden, wie die Stellung 51' des Schließhakens zeigt. Anstelle der Haltestege 21 und 22 können die Innenprofilabschnitte 15 und 16 auch nur Absätze aufweisen, welche das Schließelement 51 hintergreifen und wieder freigeben kann.

Die Schranktür 30 und das Wandelement 34 können bei dieser Ausgestaltung des Rahmenschenkels 10 auch bündig mit den Außenseiten der Profilseiten 11 und 12 abschließen.

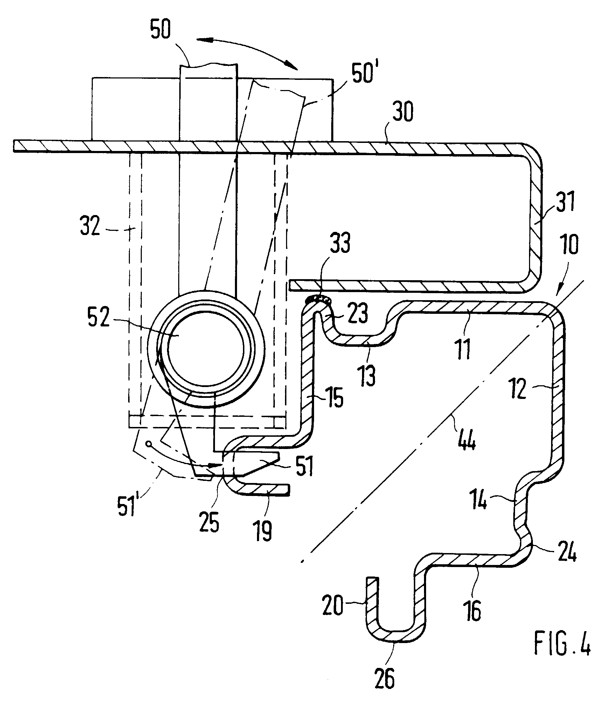

Bei dem Ausführungsbeispiel nach Fig. 4 geht die Profilseite 11 des Rahmenschenkels 10 über den zurückgesetzten Profilabschnitt 13 in den nach außen gerichteten Dichtungssteg 23 über, während bei dem zurückgesetzten Profilabschnitt 15 der Dichtungssteg 24 gegenüber der Außenseite der Profilseite 12 ebenfalls zurückgesetzt ist. Das Wandelement kann dann bündig mit der Außenseite der Profilseite 12 am Rahmenschenkel 10 abgedichtet befestigt werden. Die Innenprofilabschnitte 15 und 16 sind an den Enden mit U-förmigen, nach ihren Außenseiten gewölbten Abschnitten abgeschlossen, so daß die Verbindungsabschnitte 19 und 20 als Teile dieser U-förmigen Abschnitte senkrecht zueinander stehen und parallel zu ihren zugeordneten Profilseiten 11 und 12 verlaufen. Diese U-förmigen Abschnitte weisen als Durchbrüche ausgebildete Aufnahmen 25 und 26 auf, in die das Schließelement 51 einführbar und wieder aus diesem herausführbar ist. Anstelle des in Fig. 4 gezeigten Schließmechanismus kann auch hier ein Schließmechanismus nach Fig. 1 verwendet werden. Wesentlich ist nur, daß das Schließelement 40 so ausgebildet ist, daß es in die Aufnahme 25 bzw. 26 eingeführt werden kann. Das Schließelement 40 bzw. 51 ist wieder mittels einer Feder vorgespannt und kann mit einer Einführschräge versehen sein, so daß beim Einführen in die Aufnahme 25 bzw. 26 die Schranktür 30 gegen den Rahmenschenkel 10 gezogen wird.

## Patentansprüche

1. Schaltschrank mit einem Rahmengestell aus Rahmenschenkeln (10), dessen Außenseiten mittels Wandelementen (34) und mindestens einer Schranktür (30) verschließbar sind, welche an einem vertikalen Rahmenschenkel angelenkt und mittels Schließelementen (40, 51) an einem benachbarten vertikalen Rahmenschenkel festlegbar und wieder freigebbar ist, bei dem die vertikalen Rahmenschenkel (10) als offenes oder geschlossenes Hohlprofil ausgebildet sind, wobei die vertikalen Rahmenschenkel (10) senkrecht zu den Außenseiten des Rahmengestelles stehende Innenprofilabschnitte (15, 16) aufweisen, in die Innenprofilabschnitte (15, 16) zum Innenraum des Rahmengestelles hin offene Aufnahmenuten (17, 18) eingeformt sind, und in die Aufnahmenuten (17, 18) an der Innenseite der Schranktür (30) verstellbar gelagerte Schließelemente (40, 51) einführbar und wieder herausführbar sind,
dadurch gekennzeichnet,
daß die vertikalen Rahmenschenkel (10) des Rahmengestelles symmetrisch zu einer zwischen den senkrecht aufeinanderstoßenden Außenseiten des Rahmengestelles verlaufenden Diagonale (44) ausgebildet und ausgerichtet sind, wobei beide Innenprofilabschnitte (15, 16) jedes vertikalen Rahmenschenkels (10) mit den offenen Aufnahmenuten (17, 18) versehen sind.

2. Schaltschrank mit einem Rahmengestell aus Rahmenschenkeln (10), dessen Außenseiten mittels Wandelementen (34) und mindestens einer Schranktür (30) verschließbar sind, welche an einem vertikalen Rahmenschenkel angelenkt und mittels Schließelementen (51) an einem benachbarten vertikalen Rahmenschenkel festlegbar und wieder freigebbar ist, bei dem die vertikalen Rahmenschenkel (10) als offenes oder geschlossenes Hohlprofil ausgebildet sind, wobei die vertikalen Rahmenschenkel (10) senkrecht zu den zugeordneten Außenseiten des Rahmengestelles stehende Innenprofilabschnitte (15, 16) zum Innenraum des Rahmengestelles gerichtete und parallel zu den zugeordneten Außenseiten des Rahmengestelles verlaufende Haltestege (21, 22) oder Absätze tragen und an der Innenseite der Schranktür (30) verstellbar gelagerte Schließelemente (51) die Haltestege (21 bwz. 22) oder Absätze hintergreifen und wieder freigeben,
dadurch gekennzeichnet,
daß die Schließelemente (51) als Schließhaken ausgebildet sind, die mittels einer im Hohlprofilabschnitt (32) drehbar gelagerten, federbelasteten Betätigungswelle (52) verschwenkbar sind und aus dem Hohlprofilabschnitt (32) ragen, so daß sie hinter den zugekehrten Haltesteg (21) einführbar und wieder herausführbar sind (Fig. 3 und 4).

3. Schaltschrank mit einem Rahmengestell aus Rahmenschenkeln (10), dessen Außenseiten mittels Wandelementen (34) und mindestens einer Schranktür (30) verschließbar sind, welche an einem vertikalen Rahmenschenkel (10) angelenkt und mittels Schließelementen (40, 51) an einem benachbarten vertikalen Rahmenschenkel festlegbar und wieder freigebbar ist, bei dem die vertikalen Rahmenschenkel (10) als offenes oder geschlossenes Hohlprofil ausgebildet sind, wobei die vertikalen Rahmenschekel (10) senkrecht zu den zugeordneten Außenseiten des Rahmengestelles stehende Innenprofilabschnitte (15, 16) aufweisen, in die Innenprofilabschnitte (15, 16) Aufnahmen (25, 26) eingebracht sind und an der Innenseite der Schranktür (30) verstellbar gelagerte Schließelemente (51) in die Aufnahmen (25, 26) der Innenprofilabschnitte (15, 16) einführbar und wieder herausführbar sind,
dadurch gekennzeichnet,
daß die Innenprofilabschnitte (15, 16) an ihren Enden mit U-förmigen, nach ihren Außenseiten gewölbten Abschnitten abgeschlossen sind und
daß die Aufnahmen (25, 26) als Durchbrüche in den U-förmigen Abschnitten ausgebildet sind.

4. Schaltschrank nach einem der Ansprüche 1 bis 3,
dadurch gekennzeichnet,
daß die Schließelemente (40, 51) in einem Hohlprofilabschnitt (32) gelagert sind, der im Bereich der Schließseite auf der Innenseite der Schranktür (30) befestigt ist, und
daß die Schließelemente (40, 51) mittels Handhaben (50) oder eines Schlosses von der Außenseite der Schranktür (30) aus bedienbar sind.

5. Schaltschrank nach einem der Ansprüche 1 bis 4,
dadurch gekennzeichnet,
daß die Schließelemente (40, 51) mittels Federn (52) abgefedert sind.

6. Schaltschrank nach einem der Ansprüche 1 bis 5,
dadurch gekennzeichnet,
daß die Schließelemente (40, 51) einer Schranktür (30) einzeln oder gemeinsam verstellbar sind.

7. Schaltschrank nach Anspruch 1 und 4,
dadurch gekennzeichnet,
daß die Schließelemente (40) als federbelasteter Schieber ausgebildet sind, die mittels einer in dem Hohlprofilabschnitt (32) axial verstellbaren Betätigungsstange (41) über einen Durchbruch (43) des Hohlprofilabschnittes (32) aus diesem herausführbar und wieder in diesen hineinführbar sind (Fig. 1 und 2).

8. Schaltschrank nach einem der Ansprüche 3 bis 6,
dadurch gekennzeichnet,
daß die Schließelemente (51) als Schließhaken ausgebildet sind, die mittels einer im Hohlprofilabschnitt (32) drehbar gelagerten, federbelasteten Betätigungswelle (52) verschwenkbar sind und aus dem Hohlprofilabschnitt (32) ragen, so daß sie in die Aufnahme (25) des zugekehrten Innenprofilabschnittes (15) einführbar und wieder herausführbar sind (Fig. 3 und 4).

## Claims

1. Switchgear cabinet, having a framework formed from frame pieces (10), the external surfaces of which cabinet are closable by means of wall members (34) and at least one cabinet door (30), which is pivotally mounted on a vertical frame piece and is securable on an adjacent vertical frame piece by means of closing members (40, 51) and releasable again therefrom, wherein the vertical frame pieces (10) are configured as an open or closed hollow profile, the vertical frame pieces (10) having internal profile portions (15, 16), which extend perpendicular to the external surfaces of the framework, receiving grooves (17, 18), which are open towards the interior of the framework, being provided in the internal profile portions (15, 16), and closing members (40, 51), which are displaceably mounted on the internal surface of the cabinet door (30), being insertable in the receiving grooves (17, 18) and being removable again therefrom, characterised in that the vertical frame pieces (10) of the framework are provided and aligned symmetrically relative to a diagonal (44), which extends between the perpendicularly abutting external surfaces of the framework, both internal profile portions (15, 16) of each vertical frame piece (10) being provided with the open receiving grooves (17, 18).

2. Switchgear cabinet, having a framework formed from frame pieces (10), the external surfaces of which cabinet are closable by means of wall members (34) and at least one cabinet docr (30), which is pivotally mounted on a vertical frame piece and is securable on an adjacent vertical frame piece by means of closing members (51) and releasable again therefrom, wherein the vertical frame pieces (10) are configured as an open or closed hollow profile, the vertical frame pieces (10) carrying internal profile portions (15, 16), which extend perpendicular to the associated external surfaces of the framework, and retaining ribs (21, 22) or shoulder portions, which are orientated towards the interior of the framework and extend parallel to the associated external surfaces of the framework, and closing members (51), which are displaceably mounted on the internal surface of the cabinet door (30), engaging behind the retaining ribs (21 and 22 respectively) or shoulder portions and releasing such again, characterised in that the closing members (51) are configured as closing hooks, which are pivotable by means of a spring-loaded actuating spindle (52) rotatahly mounted in the hollow profile portion (32) and protrude from the hollow profile portion (32) so that they are insertable behind the facing retaining rib (21) and are removable again therefrom (Figs. 3 and 4).

3. Switchgear cabinet, having a framework formed from frame pieces (10), the external surfaces of which cabinet are closable by means of wall members (34) and at least one cabinet door (30), which is pivotally mounted on a vertical frame piece (10) and is securable on an adjacent vertical frame piece by means of closing members (40, 51) and is releasable again therefrom, wherein the vertical frame pieces (10) are configured as an open or closed hollow profile, the vertical frame pieces (10) having internal profile portions (15, 16), which extend perpendicular to the associated external surfaces of the framework, receiving means (25, 26) being provided in the internal profile portions (15, 16), and closing members (51), which are displaceably mounted on the internal surface of the cabinet door (30), being insertable in the receiving means (25, 26) of the internal profile portions (15, 16) and being removable again therefrom, characterised in that the internal profile portions (15, 16) are terminated at their ends with U-shaped portions, which are curved towards their external surfaces, and in that the receiving means (25, 26) are configured as openings in the U-shaped portions.

4. Switchgear cabinet according to one of claims 1 to 3, characterised in that the closing members (40, 51) are mounted in a hollow profile portion (32), which is secured in the region of the closing side on the internal surface of the cabinet door (30), and in that the closing members (40, 51) are operable by means of handles (50) or a lock from the external surface of the cabinet door (30).

5. Switchgear cabinet according to one of claims 1 to 4, characterised in that the closing members (40, 51) are spring-mounted by means of springs (52).

6. Switchgear cabinet according to one of claims 1 to 5, characterised in that the closing members (40, 51) of a cabinet door (30) are displaceable individually or together.

7. Switchgear cabinet according to claims 1 and 4, characterised in that the closing members (40) are each configured as a spring-loaded slide, which members are removable from the hollow profile portion (32) and re-insertable therein by means of an actuating rod (41), which is axially displaceable in the hollow profile portion (32), via an opening (43) in said hollow profile portion (Figs. 1 and 2).

8. Switchgear cabinet according to one of claims 3 to 6, characterised in that the closing members (51) are configured as closing hooks, which are pivotable by means of a spring-loaded actuating shaft (52) rotatably mounted in the hollow profile portion (32) and protrude from the hollow profile portion (32) so that they are insertable in the receiving means (25) of the facing internal profile portion (15) and are removable again therefrom (Figs. 3 and 4).

## Revendications

1. Armoire de distribution à bâti constitué de montants (10), dont les faces extérieures peuvent être fermées au moyen d'éléments de paroi (34) et d'au moins une porte d'armoire (30), porte qui peut être articulée sur un montant vertical et qui au moyen d'éléments de fermeture (40, 51) peut être verrouillée sur un montant vertical voisin et qui peut en être déverrouillée, armoire dont les montants verticaux (10) ont la forme d'un profilé creux ouvert ou fermé, armoire dont les montants verticaux (10) ont la forme d'un profilé creux ouvert ou fermé, les montants verticaux (10) présentant des tronçons de profil intérieurs (15, 16) perpendiculaires aux faces extérieures du bâti, des rainures de réception (17, 18) ouvertes vers l'intérieur du bâti étant formées dans les tronçons de profil intérieurs (15, 16) et des éléments de fermeture (40, 51) montés de manière réglable sur la face intérieure de la porte d'armoire (30) pouvant être engagés dans les rainures de réception (17, 18) et pouvant en être dégagés,
caractérisée
en ce que les montants verticaux (10) du bâti sont formés et orientés symétriquement à une diagonale (44) située entre les faces extérieures perpendiculaires l'une à l'autre du bâti, les deux tronçons de profil intérieurs (15, 16) de chaque montant vertical (10) présentant les rainures de réception ouvertes (17, 18).

2. Armoire de distribution à bâti constitué de montants (10), dont les faces extérieures peuvent être fermées au moyen d'éléments de paroi (34) et d'au moins une porte d'armoire (30), porte qui est articulée sur un montant vertical et qui au moyen d'éléments de fermeture (51) peut être verrouillée sur un montant vertical voisin et peut en être déverrouillée, où les montants verticaux (10) ont la forme d'un profilé creux ouvert ou fermé, où les montants verticaux (10) portent des tronçons de profilés intérieurs perpendiculaires aux faces extérieures correspondantes du bâti et orientés en direction de l'intérieur du bâti et des nervures de support ou épaulements (21, 22) disposés parallèlement aux faces extérieures correspondantes du bâti et où des éléments de fermeture (51) montés de manière réglable sur la face intérieure de la porte d'armoire viennent s'engager derrière les nervures de support (21 ou 22) ou les épaulements et peuvent s'en dégager,
caractérisé
en ce que les éléments de fermeture (51) ont la forme de crochets de fermeture qui peuvent être pivotés au moyen d'un arbre de commande (52) sollicité par un ressort et monté à rotation dans le tronçon de profil creux (32) et qui font protubérance sur le tronçon de profil creux (32), de sorte qu'ils peuvent être engagés derrière la nervure de support correspondante et peuvent en être de nouveau dégagés (Figs. 3 et 4).

3. Armoire de distribution à bâti constitué de montants (10), dont les faces extérieures peuvent être fermées au moyen d'éléments de paroi (34) et d'au moins une porte d'armoire (30), porte qui peut être articulée sur un montant vertical et qui au moyen d'éléments de fermeture (40, 51) peut être verrouillée sur un montant vertical voisin et qui peut en être déverrouillée, armoire où les montants verticaux (10) ont la forme d'un profilé creux ouvert ou fermé, armoire dont les montants verticaux (10) présentent des tronçons de profilés intérieurs (15, 16) perpendiculaires aux faces extérieures associées du bâti, tronçons de profilés creux dans lesquels sont pratiqués des logements récepteurs (25, 26) et où la face intérieure de la porte d'armoire (30) des éléments de fermeture (51) montés de manière réglable peuvent être engagés dans les logements récepteurs (25, 26) et peuvent en être dégagés,
caractérisée
en ce que les tronçons de profilés intérieurs (15, 16) sont clôturés à leurs extrémités par des tronçons en forme de U à faces extérieures bombées et
en ce que les logements récepteurs (25, 26) ont la forme de percements dans les tronçons en forme de U.

4. Armoire de distribution suivant l'une quelconque des revendications de 1 à 3,
caractérisée
en ce que les éléments de fermeture (40, 51) sont montés dans un tronçon de profilé creux (32), qui est fixé dans la région du côté de fermeture à la face intérieure de la porte d'armoire (30), et
en ce que les éléments de fermeture (40, 51) sont manoeuvrés au moyen de poignées (50) ou d'une serrure depuis la face extérieure de la porte d'armoire (30).

5. Armoire de distribution suivant l'une quelconque des revendications de 1 à 4,
caractérisée
en ce que les éléments de fermeture (40, 51) sont sollicités par des ressorts (52).

6. Armoire de distribution suivant l'une quelconque des revendications de 1 à 5,
caractérisée
en ce que les éléments de fermeture (40, 51) d'une porte d'armoire (30) peuvent être commandés individuellement ou conjointement.

7. Armoire de distribution suivant l'une quelconque des revendications de 1 à 4,
caractérisée
en ce que les éléments de fermeture (40) ont la forme de verrous sollicités par des ressorts, verrous qui au moyen d'une tringle de commande (41) réglable axialement dans le tronçon de profilé creux (32) peuvent, au travers un percement (43) dans le tronçon de profilé creux (32), être sortis de ce tronçon et peuvent de nouveau y être introduits (Figs. 1 et 2).

8. Armoire de distribution suivant l'une quelconque des revendications de 3 à 6,
caractérisée
en ce que les éléments de fermeture (51) ont le forme de crochets de fermeture, qui au moyen d'un arbre de commande (52) monté à rotation dans le tronçon de profilé creux (32) et sollicité par un ressorts peuvent être pivotés et qui font protubérance du tronçon de profilé creux (32), de sorte qu'ils peuvent être engagés dans le logement récepteur (25) du tronçon de profilé creux (15) qui leur fait face et qu'ils peuvent en être de nouveau dégagés (Figs. 3 et 4).
